# EUROPÄISCHE PATENTSCHRIFT

(11) **EP 2 484 106 B1**
(45) Veröffentlichungstag und Bekanntmachung des Hinweises auf die Patenterteilung: **31.05.2017**
(21) Anmeldenummer: 10754323.3
(22) Anmeldetag: 14.09.2010
(51) Int. Cl.: H04N 5/225, H04N 5/235, G03B 15/02, G03B 15/05

(54) **BELEUCHTUNGSEINRICHTUNG FÜR EINE KAMERA SOWIE VERFAHREN ZUM BETRIEB DERSELBEN**
LIGHTING DEVICE FOR A CAMERA AND METHOD FOR OPERATING THE SAME
DISPOSITIF D'ÉCLAIRAGE POUR UNE CAMÉRA AINSI QUE SON PROCÉDÉ DE FONCTIONNEMENT

(30) Priorität: 30.09.2009 DE 102009047788
(43) Veröffentlichungstag der Anmeldung: 08.08.2012
(60) Teilanmeldung: 17167911.1
(73) Patentinhaber: OSRAM Opto Semiconductors GmbH, 93055 Regensburg (DE)
(72) Erfinder: MOOSBURGER, Jürgen, 93055 Regensburg (DE); MORGOTT, Stefan, 93080 Pentling (DE); VON MALM, Norwin, 93152 Nittendorf - Thumhausen (DE); STREPPEL, Ulrich, 93059 Regensburg (DE); BRANDL, Michael, 93098 Mintraching (DE)
(74) Vertreter: Epping - Hermann - Fischer
(86) Internationale Anmeldenummer: PCT/EP2010/063465
(87) Internationale Veröffentlichungsnummer: WO 2011/039052

(56) Entgegenhaltungen:
- JP-A- 2003 098 580
- US-A1- 2003 174 499
- US-A1- 2005 073 849
- US-A1- 2005 168 965
- US-A1- 2006 081 773
- US-A1- 2008 151 052

## Beschreibung

Die vorliegende Offenbarung betrifft einen Licht emittierenden Halbleiterchip für eine Beleuchtungseinrichtung, eine Beleuchtungseinrichtung für eine Kamera, eine Kamera, ein Verfahren zum Betrieb der Beleuchtungseinrichtung und ein Verfahren zum Betrieb der Kamera.

Kameras mit herkömmlichen Blitzlichtern haben den Nachteil, dass die Blitzlichter eine festgelegte Abstrahlcharakteristik aufweisen. So kann es dazu kommen, dass bei einem von der Kamera aufgenommenen Bild ein im Vordergrund befindliches Motiv überbelichtet ist, während die Hintergrundbeleuchtung unzureichend sein kann. Eine Möglichkeit zur Lösung dieses Problems wäre, eine Bildfolge von verschieden stark belichteten Bildern aufzunehmen und rechnerisch zu überlagern. Dies stellt hohe Anforderungen an die Speicherkapazität und Rechenleistung der Kamera und verursacht einen hohen Stromverbrauch, was insbesondere bei Batterie betriebenen Geräten wie Kameras nachteilig ist.

Die Druckschrift JP 2008084600 A offenbart ein Blitzlicht für eine Kamera eines Mobiltelefons, bei dem die Position einer LED in einem Reflektor mittels eines Stellmotors geändert werden kann. Auf diese Weise kann der vom Blitzlicht insgesamt beleuchtete Bereich besser an den Bildausschnitt angepasst werden. Das grundsätzliche Problem einer möglichen Überbelichtung eines Motivs im Vordergrund bleibt bei diesem Blitzlicht jedoch ungelöst. Zudem ist ein derartiges Blitzlicht technisch kompliziert und, beispielsweise aufgrund der beweglichen Teile, fehleranfällig. Es ist teuer und hat einen großen Stromverbrauch.

Die Druckschriften US 2003/0174499 A1, US 2008/0151052 A1, US 2005/0168965 A1 und WO 2005/012997 A2 beschreiben jeweils eine Anordnung von Licht emittierenden Dioden, die etwa zueinander elektrisch in Reihe verschaltet sind, wobei Strahlungsprofile der Licht emittierenden Dioden mittels elektronischer Bauelemente gesteuert werden können.

Es ist daher eine Aufgabe der vorliegenden Offenbarung, eine Beleuchtungseinrichtung anzugeben, mit der ein vorgegebener Raumwinkelbereich, insbesondere ein von einer Kamera abzubildender Raumwinkelbereich, in einfacher Weise variabel ausgeleuchtet werden kann.

Diese Aufgabe wird durch eine Beleuchtungseinrichtung und ein Verfahren zum Betrieb der Beleuchtungseinrichtung gemäß den unabhängigen Patentansprüchen gelöst. Vorteilhafte Ausgestaltungen der Beleuchtungseinrichtung und des Verfahrens sind jeweils in den abhängigen Ansprüchen angegeben, deren Offenbarungsgehalt hiermit ausdrücklich durch Rückbezug in die Beschreibung aufgenommen wird.

Gemäß zumindest einem Aspekt wird ein Licht emittierender Halbleiterchip für eine Beleuchtungseinrichtung angegeben. Der Halbleiterchip enthält zweckmäßigerweise eine Halbleiterschichtenfolge mit einer zur Lichterzeugung vorgesehenen aktiven Zone. Die aktive Zone weist insbesondere einen pn-Übergang, eine Doppelheterostruktur, eine Einfach-Quanten-topfstruktur und/oder eine Mehrfach-Quantentopfstruktur zur Strahlungserzeugung auf.

Der Halbleiterchip enthält eine Mehrzahl von einzeln ansteuerbaren Emissionsbereichen. Insbesondere können die Emissionsbereiche unabhängig voneinander betrieben werden. In den Emissionsbereichen kann zu gleichen oder zu unterschiedlichen Zeiten elektromagnetische Strahlung erzeugt werden. Ferner können die Emissionsbereiche mit unterschiedlicher Stromstärke bestromt werden, sodass von den Emissionsbereichen elektromagnetische Strahlung mit voneinander unterschiedlicher Intensität erzeugt werden kann. Vorzugsweise sind die einzeln ansteuerbaren Emissionsbereiche unabhängig voneinander ein- und ausschaltbar. Die Emissionsbereiche können gleichartig gebildete aktive Zonen aufweisen, sodass die in den Emissionsbereichen erzeugte elektromagnetische Strahlung jeweils die gleiche Spektralverteilung aufweist.

Die Erzeugung der Emissionsbereiche kann beispielsweise durch die Strukturierung eines elektrischen Kontakts des Licht emittierenden Halbleiterchips erfolgen. Bevorzugt wird dabei derjenige Kontakt strukturiert, der die schlechtere Querleitfähigkeit aufweist. Die Emissionsbereiche können dann eine gemeinsame aktive Zone umfassen, die sich lateral durch sämtliche Emissionsbereiche erstreckt, sodass die aktiven Zonen der Emissionsbereiche gleichartig aufgebaut sind.

Gemäß zumindest einer Ausgestaltung ist die Strukturierung des Kontakts durch vollständige Abwesenheit des Kontakts an den Stellen zwischen den Emissionsbereichen realisiert. Alternativ ist es möglich, dass zwischen den Emissionsbereichen Stellen mit hohem Kontaktwiderstand vorhanden sind, die zu einer elektrischen Entkopplung der Emissionsbereiche führen. Der strukturierte elektrische Kontakt wird beispielsweise von einer auf die Halbleiterschichtenfolge aufgebrachten, insbesondere segmentierten, Metallschicht gebildet.

Gemäß zumindest einer Ausgestaltung ist zur Ausbildung der Emissionsbereiche alternativ oder zusätzlich die Halbleiterschichtenfolge des Licht emittierenden Halbleiterchips, welche die Emissionsbereiche enthält, strukturiert. Beispielsweise ist die aktive Zone zur Ausbildung der einzelnen Emissionsbereiche durchtrennt. Hierzu können in der Halbleiterschichtenfolge zwischen den Emissionsbereichen Gräben ausgebildet sein, etwa mittels eines Säge- und/oder Ätzprozesses.

Mittels der Segmentierung des Kontakts und/oder der Halbleiterschichtenfolge eines einzelnen Halbleiterchips zu den Emissionsbereichen können die Emissionsbereiche innerhalb eines besonders kleinen Leuchtfelds angeordnet werden. Auf diese Weise sind mit Vorteil besonders kleine Baugrößen der Beleuchtungseinrichtung erzielbar.

Gemäß zumindest einer Ausgestaltung weist mindestens einer der Emissionsbereiche ein Lumineszenzkonversionselement auf, das beispielsweise auf die Halbleiterschichtenfolge aufgebracht sein kann. Die aktive Zone eines Emissionsbereichs mit Lumineszenzkonversionselement ist zweckmäßigerweise zur Erzeugung von elektromagnetischer Primärstrahlung vorgesehen. Das Lumineszenzkonversionselement ist insbesondere zur Absorption von Primärstrahlung der aktiven Zone und zur Emission von Sekundärstrahlung ausgebildet. Ein Intensitätsmaximum der Sekundärstrahlung ist vorzugsweise gegenüber einem Intensitätsmaximum der Primärstrahlung zu größeren Wellenlängen hin spektral verschoben. Beispielsweise liegen das Intensitätsmaximum der Primärstrahlung im blauen Spektralbereich und das Intensitätsmaximum der Sekundärstrahlung im gelben Spektralbereich. Bei einer Ausgestaltung ist der Emissionsbereich und/oder der Halbleiterchip dazu ausgebildet, Mischlicht aus der Primärstrahlung und der Sekundärstrahlung, zum Beispiel weißes Licht, zu emittieren.

Die Emissionsbereiche können derart ausgebildet sein, dass alle Emissionsbereiche den gleichen Farbeindruck hervorrufen. Beispielsweise sind alle Emissionsbereiche zur Emission von Licht mit einem Farbort im weißen Bereich der CIE-Norm-Farbtafel ausgebildet. Alternativ können sich mindestens zwei der Emissionsbereiche hinsichtlich des Farborts des vom jeweiligen Emissionsbereich emittierten Lichts unterscheiden. Beispielsweise emittiert ein erster Emissionsbereich Licht, das einen ersten Farbort in der CIE-Norm-Farbtafel hat. Ein zweiter Emissionsbereich hat einen zweiten, vom ersten verschiedenen Farbort in der CIE-Norm-Farbtafel.

Gemäß zumindest einer Ausgestaltung umfasst der Leuchtdiodenchip zumindest zwei unterschiedlich ausgestaltete Lumineszenzkonversionselemente um die unterschiedlichen Farborte zu erzielen. Beispielsweise sind die unterschiedlich ausgestalteten Lumineszenzkonversionselement verschiedenen Emissionsbereichen zugeordnet, die mittels der unterschiedlich ausgestalteten Lumineszenzkonversionselemente zur Emission verschiedenfarbigen Mischlichts ausgebildet sind. "Unterschiedlich ausgestaltet" bedeutet dabei insbesondere, dass die Lumineszenzkonversionselemente, wenn sie mit elektromagnetischer Strahlung derselben Wellenlänge und derselben Intensität durchstrahlt werden, voneinander unterschiedliche Sekundärstrahlung emittieren. Beispielsweise können sich die Konversionselemente hinsichtlich ihrer geometrischen Abmessungen, wie beispielsweise ihrer Dicke, und/oder ihrer Zusammensetzung voneinander unterscheiden. Beispielsweise kann ein erstes Konversionselement einen ersten Leuchtstoff enthalten, während das zweite Konversionselement einen zweiten Leuchtstoff enthält.

Gemäß zumindest einer Ausgestaltung weist jeder Emissionsbereich an einer Vorderseite des Halbleiterchips eine Emissionsfläche zur Lichtauskopplung auf. Der Halbleiterchip ist zweckmäßigerweise zur Lichtauskopplung von seiner Vorderseite vorgesehen. Jedem Emissionsbereich sind zwei Leiterbahnen des Halbleiterchips zum elektrischen Anschluss des jeweiligen Emissionsbereichs zugeordnet. Beispielsweise ist eine der Leiterbahnen zur n-seitigen Kontaktierung des Emissionsbereichs und die andere Leiterbahn zur p-seitigen Kontaktierung des Emissionsbereichs ausgebildet. Die jeweiligen Emissionsflächen überdecken vorzugsweise in Draufsicht auf die Vorderseite die dem jeweiligen Emissionsbereich zugeordneten Leiterbahnen. Insbesondere sind die Leiterbahnen demnach von einer vorderseitigen Hauptfläche der Halbleiterschichtenfolge überdeckt.

Auf diese Weise kann mit Vorteil eine besonders große Emissionsfläche der Emissionsbereiche erzielt werden. Insbesondere ist die vorderseitige Hauptfläche der Halbleiterschichtenfolge frei von elektrischen Anschlussflächen wie Bondpads. In Draufsicht auf die Vorderseite sind insbesondere auch keine Bonddrähte oder Leiterbahnen über die vorderseitige Hauptfläche der Halbleiterschichtenfolge gezogen. Sowohl die n-seitige als auch die p-seitige Kontaktierung der Halbleiterschichtenfolge erfolgt vorteilhafterweise von einer rückseitigen Hauptfläche der Halbleiterschichtenfolge her.

Jedem Emissionsbereich können ein separater Kathodenanschlussbereich und ein separater Anodenanschlussbereich zur externen elektrischen Kontaktierung des Halbleiterchips zugeordnet sein. Gemäß einer anderen Ausgestaltung sind mindestens zwei Emissionsbereiche in Reihe geschaltet. Bei einer Weiterbildung sind alle Emissionsbereiche in Reihe geschaltet. In diesem Fall sind alle Emissionsbereiche gemeinsam mittels zwei Elektrodenanschlussbereichen, nämlich einem gemeinsamen Kathodenanschlussbereich und einem gemeinsamen Anodenanschlussbereich elektrisch angeschlossen. Insbesondere weist der Halbleiterchip genau zwei Elektrodenanschlussbereiche zur externen elektrischen Kontaktierung des Halbleiterchips auf, nämlich den gemeinsamen Kathodenanschlussbereich und den gemeinsamen Anodenanschlussbereich.

Gemäß zumindest einer Ausgestaltung weist der Halbleiterchip zwei externe Anschlussfelder auf, die zum Überbrücken eines Emissionsbereichs, insbesondere genau eines Emissionsbereichs, elektrisch leitend verbindbar sind. Beispielsweise ist ein erstes der externen Anschlussfelder mit einer ersten der dem Emissionsbereich zugeordneten Leiterbahnen verbunden und das zweite externe elektrische Anschlussfeld ist mit der zweiten, dem Emissionsbereich zugeordneten Leiterbahn verbunden. Insbesondere ist der Halbleiterchip derart verschaltet, dass ein elektrisches oder elektronisches Element, beispielsweise ein Widerstand, ein Transistor oder ein Schalter, der an den zwei externen Anschlussfeldern angeschlossen ist, parallel zum Emissionsbereich geschaltet ist. Auf diese Weise kann der Emissionsbereich beispielsweise mittels des Schalters oder Transistors kurzgeschlossen sein. Bei einer Ausgestaltung ist jedem Emissionsbereich ein Paar von externen Anschlussfeldern zugeordnet, die zum Überbrücken des jeweiligen Emissionsbereichs elektrisch leitend verbindbar sind.

Eine Ausgestaltung mit überbrückbaren Emissionsbereichen ist insbesondere zweckmäßig, wenn mindestens zwei Emissionsbereiche in Reihe geschaltet sind. Mittels der externen Anschlussfelder sind die Emissionsbereich vorteilhafterweise einzeln ansteuerbar, obwohl sie in Reihe geschaltet sind.

Gemäß einer weiteren Ausgestaltung sind mindestens zwei Emissionsbereiche, insbesondere alle Emissionsbereiche, zueinander elektrisch parallel geschaltet. Die zueinander parallel geschalteten Emissionsbereiche weisen beispielsweise einen gemeinsamen Kathodenanschlussbereich zum externen elektrischen Anschluss auf. Jedem der parallel geschalteten Emissionsbereiche ist ein separater Anodenanschlussbereich zum externen elektrischen Anschluss zugeordnet. Auch eine Ausgestaltung mit separaten Kathodenanschlussbereichen und einem gemeinsamen Anodenanschlussbereich ist denkbar.

Gemäß zumindest einer Ausgestaltung ist die elektrische Verschaltung der Emissionsbereiche mittels elektrischen Verbindungselementen ausgeführt, welche teilweise oder vollständig auf einer rückseitigen Hauptfläche der Halbleiterschichtenfolge angeordnet sind. Beispielsweise umfassen die elektrischen Verbindungselemente, mittels welchen die Emissionsbereiche insbesondere in Reihe und/oder parallel geschaltet sind, Leiterbahnen oder sie bestehen aus Leiterbahnen. Vorzugsweise umfassen die elektrischen Verbindungselemente die zur p-seitigen und n-seitigen Kontaktierung vorgesehenen und insbesondere von den Emissionsflächen zumindest bereichsweise überdeckten Leiterbahnen. Die Leiterbahnen oder zumindest Teilstücke der Leiterbahnen sind vorzugsweise auf der rückseitigen Hauptfläche der Halbleiterschichtenfolge aufgebracht.

Beispielsweise verläuft ein elektrisches Verbindungselement, etwa eine Leiterbahn, von einem Emissionsbereich zu einem weiteren Emissionsbereich, insbesondere um diese miteinander zu verschalten. Ein in Draufsicht auf die Vorderseite zwischen den beiden Emissionsbereichen angeordnetes Teilstück des elektrischen Verbindungselement kann vollständig von der Halbleiterschichtenfolge überdeckt sein oder - beispielsweise wenn die aktive Schicht zur Ausbildung der Emissionsbereiche durchtrennt ist - von der Halbleiterschichtenfolge unbedeckt sein und insbesondere freiliegen.

Bei zumindest einer Ausgestaltung enthält der Halbleiterchip einen Trägerkörper, der insbesondere vom Aufwachssubstrat der Halbleiterschichtenfolge verschieden ist und mit dem die Halbleiterschichtenfolge mechanisch stabil verbunden ist. Zweckmäßigerweise ist die rückseitige Hauptfläche der Halbleiterschichtenfolge dem Trägerkörper zugewandt. Die elektrischen Verbindungselemente sind bei dieser Weiterbildung beispielsweise zwischen der Halbleiterschichtenfolge und dem Trägerkörper angeordnet.

Die die elektrische Verschaltung der Emissionsbereiche miteinander und/oder die elektrische Verbindung der Emissionsbereiche mit den Elektrodenanschlussbereichen, d. h. dem oder den Kathodenanschlussbereich(en) und dem oder den Anodenanschlussbereich(en), sowie gegebenenfalls mit den externen Anschlussfeldern kann vorteilhafterweise preisgünstig und zuverlässig im Herstellungsprozess des Chips erfolgen. Zum Beispiel können die Leiterbahnen mittels eines Abscheideverfahrens, etwa eines Aufdampf- oder Sputter-Verfahrens, auf der Halbleiterschichtenfolge und/oder auf dem Trägerkörper hergestellt werden. Eine nachträgliche Verschaltung der einzelnen Emissionsbereiche, zum Beispiel mit Hilfe von Bonddrähten, ist vorteilhafterweise nicht notwendig.

Die Elektrodenanschlussbereiche und gegebenenfalls die externen elektrischen Anschlussfelder sind gemäß zumindest einer Ausgestaltung an der Vorderseite des Halbleiterchips angeordnet. Beispielsweise sind sie in Draufsicht auf die Vorderseite des Halbleiterchips in einem Randgebiet zwischen den Emissionsbereichen und den Außenkanten des Halbleiterchips angeordnet. Die Elektrodenanschlussbereiche und/oder die externen Anschlussfelder können auch an einer der Vorderseite gegenüberliegenden Rückseite des Halbleiterchips angeordnet sein.

Gemäß zumindest einer Ausgestaltung ist ein erster Emissionsbereich lateral von mindestens einem weiteren Emissionsbereich umschlossen oder lateral von mehreren weiteren Emissionsbereichen umgeben. Beispielsweise ist die Emissionsfläche des ersten Emissionsbereichs in Draufsicht auf die Vorderseite des Halbleiterchips in einem Mittelbereich der Vorderseite angeordnet. Die Emissionsflächen der weiteren Emissionsbereiche sind um diese erste Emissionsfläche herum, insbesondere in einem Randbereich der Vorderseite angeordnet und/oder eine weitere Emissionsfläche umschließt die erste Emissionsfläche lateral. Beispielsweise sind mindestens vier Emissionsbereiche ringartig um den ersten Emissionsbereich angeordnet. Beispielsweise ist in Draufsicht auf die Vorderseite einer der weiteren Emissionsbereiche zwischen dem ersten Emissionsbereich und einer Kante oder Ecke des Halbleiterchips positioniert. Bei einer Ausgestaltung sind die Emissionsbereich in Draufsicht auf die Vorderseite spiegelsymmetrisch zu den Seitenhalbierenden der Außenkanten des Halbleiterchips angeordnet und/oder weisen eine vierzählige Rotationssymmetrie bezüglich der Flächennormalen der Vorderseite auf.

Gemäß zumindest einem Aspekt wird eine Beleuchtungseinrichtung, insbesondere eine Beleuchtungseinrichtung für eine Kamera, angegeben. Gemäß zumindest einer Ausgestaltung ist die Beleuchtungseinrichtung ein Blitzlicht.

Die Beleuchtungseinrichtung enthält einen Licht emittierenden Halbleiterchip. Der Licht emittierende Halbleiterchip ist beispielsweise gemäß mindestens einer der oben beschriebenen Ausgestaltungen ausgebildet.

Beispielsweise weist die Beleuchtungseinrichtung ein Leuchtfeld auf, welches die Emissionsbereiche des Licht emittierenden Halbleiterchips enthält. Mittels der einzeln ansteuerbaren Emissionsbereiche sind vorzugsweise unterschiedliche Leuchtdichteverteilungen des Leuchtfeldes einstellbar.

Die Beleuchtungseinrichtung weist vorzugsweise ein optisches Element auf, das dazu ausgebildet ist, von dem Halbleiterchip emittiertes Licht zu einem Strahlenbündel zu formen. Insbesondere ist das optische Element dazu ausgebildet, von den Emissionsbereichen des Licht emittierenden Halbleiterchips emittiertes Licht zu dem Strahlenbündel zu formen.

Das optische Element kann beispielsweise eine Linse sein. Die Linse ist beispielsweise eine sphärische, eine asphärische oder eine zylindrische Linse. Die Linse kann auch eine so genannte Freiformlinse sein. Die Freiformlinse ist beispielsweise derart geformt, dass sie das Licht der einzelnen Emissionsbereiche in unterschiedliche, aber vorbestimmte Richtungen lenkt. Vorzugsweise hat die Freiformlinse eine glatte, d. h. von Knicken und Kanten freie Lichteintrittsfläche und/oder Lichtaustrittsfläche.

Die Beleuchtungseinrichtung ist gemäß zumindest einer Ausgestaltung derart ausgebildet, dass mittels der einzeln ansteuerbaren Emissionsbereiche unterschiedliche Strahlprofile des Strahlenbündels einstellbar sind. Beispielsweise unterscheiden sich die Strahlprofile hinsichtlich der räumlichen Intensitätsverteilung und/oder hinsichtlich der räumlichen Farbortverteilung in einer - insbesondere beliebigen - zu einer Mittelachse des Strahlenbündels senkrechten Ebene.

Gemäß zumindest einer Ausführungsform ist mittels der einzeln ansteuerbaren Emissionsbereiche ein Öffnungswinkel des Strahlenbündels einstellbar. Diese Ausgestaltung ist beispielsweise zweckmäßig, wenn das Strahlenbündel ein divergentes Strahlenbündel ist.

Gemäß zumindest einer weiteren Ausgestaltung ist mittels der einzeln ansteuerbaren Emissionsbereiche die Lage eines Brennpunkts einstellbar, in welchen das Strahlenbündel von dem optischen Element fokussiert wird. Eine solche Ausgestaltung ist insbesondere zweckmäßig, wenn die Beleuchtungseinrichtung von einer Lichtauskoppelfläche des optischen Elements ein konvergentes Strahlenbündel emittiert.

Gemäß zumindest einer Ausgestaltung sind die Formgebung des optischen Elements und die Anordnung des optischen Elements zu den Emissionsbereichen derart aneinander angepasst, dass die Beleuchtungseinrichtung dazu ausgebildet ist, von einem ersten Emissionsbereich emittiertes Licht in einen ersten Abstrahlwinkelbereich zu lenken und von einem zweiten, von dem ersten verschiedenen Emissionsbereich emittiertes Licht in einen zweiten, vom ersten verschiedenen Abstrahlwinkelbereich zu lenken. Beispielsweise enthält der erste Abstrahlwinkelbereich die Mittelachse des Strahlenbündels und der zweite Abstrahlwinkelbereich ist von der Mittelachse des Strahlenbündels beabstandet.

Gemäß zumindest einer Ausgestaltung ist mittels der einzeln ansteuerbaren Emissionsbereiche ein erstes Strahlprofil einstellbar, bei dem die Strahlungsintensität des Strahlenbündels auf seiner Mittelachse ein lokales Minimum hat und die Strahlungsintensität in mindestens einer - vorzugsweise jeder - zur Mittelachse senkrechten Richtung im Verlauf von der Mittelachse weg zunächst ansteigt und nachfolgend wieder abfällt. Beispielsweise weist das Strahlenbündel die maximale Strahlungsintensität in einem ring-artigen, um die Mittelachse umlaufenden Bereich auf, etwa in einem Überlappungsbereich des ersten Abstrahlwinkelbereichs und des zweiten Abstrahlwinkelbereiches.

Bei einer bevorzugten Weiterbildung ist ein zweites Strahlprofil mittels der einzeln ansteuerbaren Emissionsbereiche einstellbar, bei dem die Strahlungsintensität auf der Mittelachse maximal ist. Insbesondere fällt die Strahlungsintensität ausgehend von der Mittelachse in jeder zur Mittelachse senkrechten Richtung im Verlauf von der Mittelachse weg ab.

Gemäß zumindest einem Aspekt wird eine Beleuchtungseinrichtung für eine Kamera angegeben, wobei die Beleuchtungseinrichtung einen Licht emittierenden Halbleiterchip aufweist, der eine Mehrzahl von einzeln ansteuerbaren Emissionsbereichen enthält, und ein optisches Element aufweist, das dazu ausgebildet ist, von den Emissionsbereichen emittiertes Licht zu einem Strahlenbündel zu formen. Die Beleuchtungseinrichtung ist derart ausgebildet, dass mittels der einzeln ansteuerbaren Emissionsbereiche unterschiedliche Strahlprofile des Strahlenbündels einstellbar sind.

Mit einer derartigen Beleuchtungseinrichtung ist - insbesondere mittels separater Ansteuerung der einzelnen Emissionsbereiche - eine in allen drei Raumrichtungen räumlich und/oder zeitlich differenzierte Beleuchtung eines Raumwinkelbereichs erzielbar, welcher von der Kamera abgebildet wird. Hierbei können mit Vorteil sowohl die Intensität als auch die Wellenlänge des Lichts räumlich und/oder zeitlich einstellbar sein.

Dabei kann mit Vorteil auf bewegliche Komponenten in der Beleuchtungseinrichtung verzichtet werden. Beispielsweise ist das optische Element ortsfest bezüglich des Licht emittierenden Halbleiterchips angeordnet. Auf diese Weise ist die Beleuchtungseinrichtung mit Vorteil besonders robust. Zudem ist ein besonders geringer Energieverbrauch der Beleuchtungseinrichtung erzielbar, beispielsweise da es nicht notwendig ist, Stellmotoren zu betreiben, um einzelne Komponenten der Beleuchtungseinrichtung gegeneinander zu bewegen.

Gemäß zumindest einer Ausgestaltung weist die Beleuchtungseinrichtung eine Speichereinheit auf. In der Speichereinheit ist eine Mehrzahl verschiedener Ansteuerungsmuster für die Ansteuerung der Emissionsbereiche zur Einstellung der unterschiedlichen Strahlprofile gespeichert und im Betrieb der Beleuchtungseinrichtung abrufbar.

Gemäß zumindest einer Ausgestaltung weist die Beleuchtungseinrichtung eine Steuereinheit auf. Die Steuereinheit kann beispielsweise dazu ausgebildet sein, zum Einstellen eines ersten Strahlprofils eine elektrisch leitende Verbindung zwischen zwei externen Anschlussfeldern herzustellen, die zum Überbrücken eines Emissionsbereichs elektrisch leitend verbindbar sind. Zum Einstellen eines zweiten Strahlprofils kann die Steuereinheit dazu vorgesehen sein, die elektrisch leitende Verbindung zu unterbrechen. Alternativ oder zusätzlich kann die Steuereinheit zur Stromzuführung an die Elektrodenanschlussbereiche ausgebildet sein. Beispielsweise handelt es sich bei der Steuereinheit um ein IC-Bauelement (IC = integrated circuit, integrierter Schaltkreis).

Gemäß zumindest einer Ausgestaltung weist die Beleuchtungseinrichtung einen Träger auf. Der Halbleiterchip, insbesondere die Rückseite des Halbleiterchips, kann an dem Träger befestigt sein. Bei dem Träger kann es sich beispielsweise um eine Leiterplatte handeln. Beispielsweise sind die Elektrodenanschlussbereiche und gegebenenfalls die externen Anschlussfelder elektrisch an Anschlussleiter der Leiterplatte angeschlossen. Beispielsweise an der Rückseite des Halbleiterchips angeordnete Elektrodenanschlussbereiche und/oder externe Anschlussfelder können flächig mit den Anschlussleitern verbunden, insbesondere verlötet oder verklebt sein. Auf der Leiterplatte können weitere elektronische Bauelemente, z. B. die Speichereinheit oder die Steuereinheit, angeordnet sein.

Gemäß zumindest einem Aspekt wird eine Kamera angegeben, die eine Beleuchtungseinrichtung gemäß zumindest einer der oben erläuterten Ausgestaltungen enthält. Die Kamera ist beispielsweise zur Aufzeichnung von Bildern und/oder Bildfolgen ausgebildet. Beispielsweise handelt es sich bei der Kamera um eine Fotokamera und/oder Videokamera. Die Kamera kann in einem Mobiltelefon enthalten sein. Die Kamera kann einen Auslöser zum Starten der Aufzeichnung aufweisen. Die Kamera weist beispielsweise einen Detektor, etwa einen CCD-Detektor (CCD = charge coupled device, ladungsgekoppeltes Bauteil), zur Erfassung der Bilder auf.

Das Emissionsspektrum der Emissionsbereiche kann auf die spektrale Empfindlichkeit des Detektors abgestimmt sein. In diesem Fall kann die Beleuchtungseinrichtung auch zur räumlich und zeitlich invarianten Abstrahlung verschiedenfarbigen Lichts vorgesehen sein, um einen besonders geringen Energieverbrauch der Kamera zu erzielen.

Gemäß zumindest einem Aspekt wird ein Verfahren zum Betrieb der Beleuchtungseinrichtung bzw. zum Betrieb der Kamera mit der Beleuchtungseinrichtung angegeben. Bei dem Verfahren wird die Beleuchtungseinrichtung zunächst mit einem ersten Strahlprofil und nachfolgend mit einem zweiten, von dem ersten verschiedenen Strahlprofil betrieben.

Gemäß zumindest einer Ausgestaltung des Verfahrens werden die Emissionsbereiche derart angesteuert, dass während des Betriebs mit dem ersten Strahlprofil ein erster Emissionsbereich Licht emittiert und ein zweiter Emissionsbereich abgeschaltet ist. Während des Betriebs mit dem zweiten Strahlprofil emittiert vorzugsweise der zweite Emissionsbereich Licht. Der erste Emissionsbereich kann ebenfalls Licht emittieren oder abgeschaltet sein, während die Beleuchtungseinrichtung mit dem zweiten Strahlprofil betrieben wird.

Gemäß zumindest einer Ausgestaltung wird ein Verfahren zum Betrieb der Kamera zur Aufzeichnung einer Bildfolge angegeben. Bei dem Verfahren zeichnet die Kamera ein erstes Bild auf, während die Beleuchtungseinrichtung mit dem ersten Strahlprofil betrieben wird. Während die Beleuchtungseinrichtung mit dem zweiten Strahlprofil betrieben wird, zeichnet die Kamera ein zweites Bild auf.

Bei einer Weiterbildung des Verfahrens wird nach der Aufzeichnung des ersten und des zweiten Bildes eines der beiden Bilder ausgewählt. Das andere Bild kann beispielsweise gelöscht werden. Die Auswahl kann mittels einer Bilderkennungssoftware, insbesondere automatisch, oder durch den Benutzer erfolgen.

Gemäß zumindest einer Ausgestaltung wird ein Verfahren zum Betrieb der Kamera zum Aufzeichnen eines Bildes angegeben. Bei dem Verfahren wird zunächst der Auslöser zum zeitversetzten Auslösen der Erfassung des Bilds mittels des Detektors betätigt. Nachfolgend wird die Beleuchtungseinrichtung mit dem ersten Strahlprofil betrieben. Nachfolgend auf das Betreiben mit dem ersten Strahlprofil wird die Beleuchtungseinrichtung mit dem zweiten Strahlprofil betrieben. Dabei erfolgt das Betreiben der Beleuchtungseinrichtung mit dem ersten Strahlprofil insbesondere vor der Erfassung des Bilds mittels des Detektors. Der Betrieb der Beleuchtungseinrichtung mit dem zweiten Strahlprofil überlappt vorzugsweise zeitlich mit der Erfassung des Bildes mittels des Detektors. Insbesondere wird die Beleuchtungseinrichtung mit dem zweiten Strahlprofil betrieben, während der Detektor das Bild erfasst.

Gemäß zumindest einer Ausgestaltung wird die Beleuchtungseinrichtung zum Betrieb mit dem ersten Strahlprofil derart angesteuert, dass nur einer oder nur einige der Emissionsbereiche Licht emittieren. Die Emissionsbereiche können beispielsweise derart ausgewählt sein, dass das von der Beleuchtungseinrichtung emittierte Strahlenbündel räumlich auf einen Mittelbereich desjenigen Raumwinkelbereichs begrenzt ist, der von der Kamera auf das Bild abgebildet wird. Beispielsweise kann das Strahlenbündel räumlich auf einen Autofokusbereich der Kamera begrenzt sein. Bei dem Betrieb der Beleuchtungseinrichtung mit dem ersten Strahlprofil kann es sich beispielsweise um einen Vorblitz, etwa zur Reduktion des sogenannten "Rote-Augen-Effekts", handeln.

Zum Betrieb der Beleuchtungseinrichtung mit dem zweiten Strahlprofil können andere Emissionsbereiche als zum Betrieb mit dem ersten Strahlprofil oder alle Emissionsbereiche angesteuert werden, sodass sie Licht emittieren. Beispielsweise handelt es sich beim Betrieb der Beleuchtungseinrichtung mit dem zweiten Strahlprofil um einen Hauptblitz.

Mittels des Betriebs der Beleuchtungseinrichtung mit einem oder wenigen Emissionsbereichen für den Vorblitz kann vorteilhafterweise ein besonders niedriger Energieverbrauch der Beleuchtungseinrichtung zum Aufzeichnen des Bilds erzielt werden.

Weitere Vorteile und vorteilhafte Ausgestaltungen und Weiterbildungen ergeben sich aus den folgenden, im Zusammenhang mit den Figuren erläuterten Ausführungsbeispielen.

Es zeigen:
- Figur 1,: eine Draufsicht auf einen Licht emittierenden Halbleiterchip für eine Beleuchtungseinrichtung gemäß einem ersten Ausführungsbeispiel,
- Figur 2,: eine schematische Draufsicht auf einen Licht emittierenden Halbleiterchip für eine Beleuchtungseinrichtung gemäß einem zweiten Ausführungsbeispiel,
- Figur 3,: eine schematische Draufsicht auf einen Licht emittierenden Halbleiterchip für eine Beleuchtungseinrichtung gemäß einem dritten Ausführungsbeispiel,
- Figur 4,: einen schematischen Querschnitt durch einen Licht emittierenden Halbleiterchip gemäß einer Variante des ersten Ausführungsbeispiels,
- Figur 5A,: eine schematische Draufsicht auf einen Licht emittierenden Halbleiterchip für eine Beleuchtungseinrichtung gemäß einem vierten Ausführungsbeispiel,
- Figur 5B,: eine schematische Draufsicht auf einen Licht emittierenden Halbleiterchip für eine Beleuchtungseinrichtung gemäß einem fünften Ausführungsbeispiel,
- Figur 5C,: eine schematische Draufsicht auf einen Licht emittierenden Halbleiterchip für eine Beleuchtungseinrichtung gemäß einem sechsten Ausführungsbeispiel,
- Figur 6,: einen schematischen Querschnitt durch eine Beleuchtungseinrichtung für eine Kamera gemäß einem ersten Ausführungsbeispiel,
- Figur 7,: einen schematischen Querschnitt durch eine Beleuchtungseinrichtung für eine Kamera gemäß einem zweiten Ausführungsbeispiel,
- Figur 8A,: eine schematische Darstellung der Intensitätsverteilung eines ersten Strahlprofils,
- Figur 8B,: eine schematische Darstellung der Intensitätsverteilung eines zweiten Strahlprofils, und
- Figur 9,: eine schematische Draufsicht auf ein Mobiltelefon.

In den Ausführungsbeispielen und Figuren sind gleiche, ähnliche oder ähnlich wirkende Bestandteile mit denselben Bezugszeichen versehen. Die Figuren und die Größenverhältnisse der in den Figuren dargestellten Elemente untereinander sind nicht als maßstabsgetreu zu betrachten. Vielmehr können einzelne Elemente übertrieben groß dargestellt werden, um die Darstellbarkeit und/oder Verständlichkeit zu erleichtern.

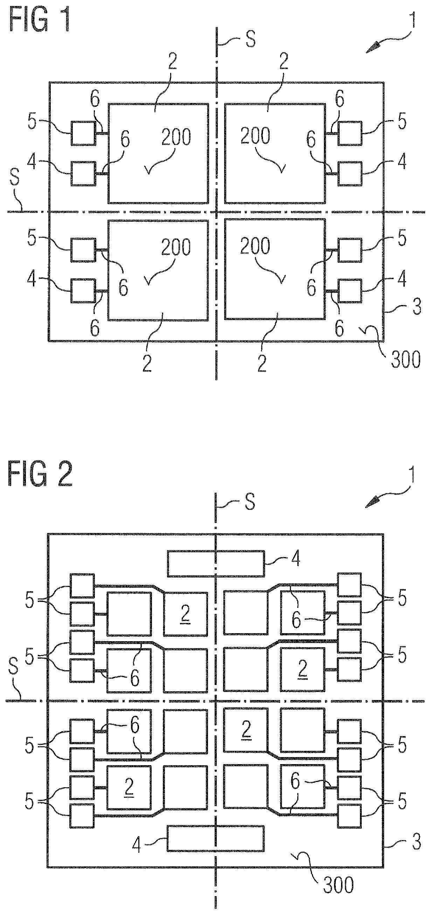

Figur 1 zeigt eine schematische Draufsicht auf eine Vorderseite eines Halbleiterchips 1 für eine Beleuchtungseinrichtung gemäß einem ersten Ausführungsbeispiel.

Der Licht emittierende Halbleiterchip 1 weist eine Mehrzahl von Emissionsbereichen 2 auf. Jeder Emissionsbereich weist eine der Vorderseite zugewandte Emissionsfläche 200 auf, welche zur Strahlungsauskopplung aus dem jeweiligen Emissionsbereich 2 vorgesehen ist. Vorliegend weist der Halbleiterchip 1 vier Emissionsbereiche 2 auf, die in Draufsicht auf die Vorderseite des Halbleiterchips 1 spiegelsymmetrisch zu den Seitenhalbierenden S der Kanten des Halbleiterchips 1 angeordnet sind. Die Anordnung der Emissionsbereiche 2 weist vorliegend auch eine vierzählige Rotationssymmetrie bezüglich einer Rotationsachse auf, die in Richtung der Flächennormalen auf die Emissionsflächen und durch den Schnittpunkt der beiden Seitenhalbierenden S verläuft.

Der Halbleiterchip 1 umfasst einen Trägerkörper 3, auf welchem die Emissionsbereiche 2 angeordnet sind. Beispielsweise kann es sich bei dem Trägerkörper 3 um ein Aufwachssubstrat handeln, auf welchem bei der Herstellung des Halbleiterchips 1 eine epitaktische Halbleiterschichtenfolge aufgewachsen wird, welche die Emissionsbereiche 2 enthält. Vorliegend handelt es sich bei dem Licht emittierenden Halbleiterchip 1 jedoch um einen so genannten Dünnfilm-Leuchtdiodenchip, bei dem das Aufwachssubstrat von der epitaktischen Halbleiterschichtenfolge entfernt oder stark gedünnt ist und die Halbleiterschichtenfolge auf einem vom Aufwachssubstrat verschiedenen Trägersubstrat 3 befestigt ist.

Die vorderseitige Hauptfläche 300 des Trägerkörpers 3 weist Elektrodenanschlussbereiche zur externen elektrischen Kontaktierung der Emissionsbereiche 2 auf. Bei dem Halbleiterchip 1 gemäß dem ersten Ausführungsbeispiel sind jedem der Emissionsbereiche 2 zwei separate Elektrodenanschlussbereiche, nämlich ein Kathodenanschlussbereich 4 und ein Anodenanschlussbereich 5 zugeordnet.

Von den jeweiligen Elektrodenanschlussbereichen 4, 5 sind Leiterbahnen 6 unter die jeweiligen Emissionsbereiche 2 gezogen. Die jeweiligen Emissionsflächen 200 überdecken die Leiterbahnen 6. Auf diese Weise sind die Emissionsbereiche 2 von einer der Vorderseite gegenüberliegenden Rückseite elektrisch angeschlossen. Die Emissionsflächen 200 sind vorteilhafterweise frei von Elektrodenanschlüssen wie Bondpads.

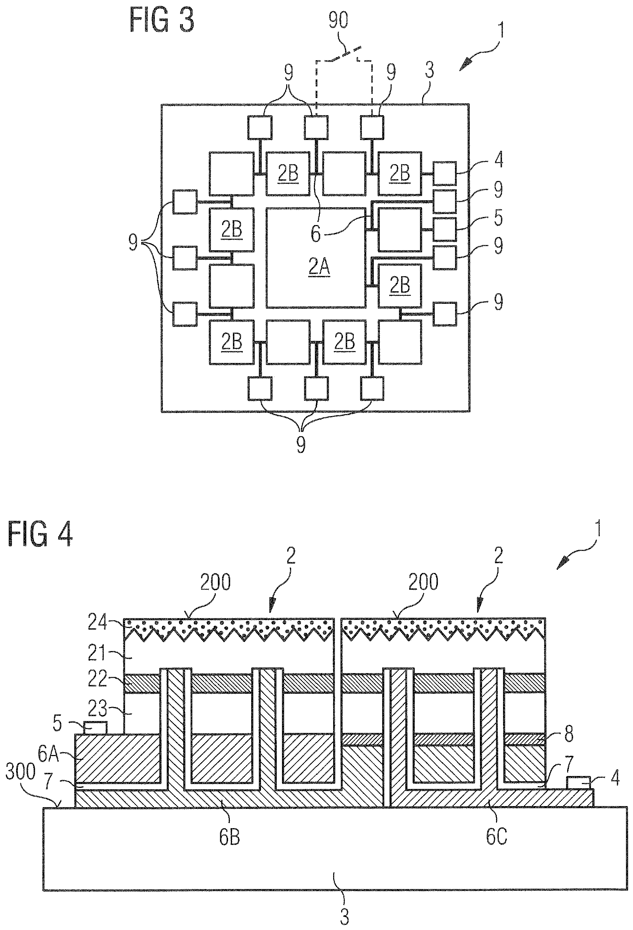

Figur 4 zeigt einen schematischen Querschnitt durch einen Licht emittierenden Halbleiterchip für eine Beleuchtungseinrichtung gemäß einer Variante des ersten Ausführungsbeispiels. Das Ausführungsbeispiel der Figur 4 unterscheidet sich dadurch von dem ersten Ausführungsbeispiel, dass nicht jedem der Emissionsbereiche 2 zwei separate Elektrodenanschlüsse 4, 5 zugeordnet sind. Vielmehr sind jeweils zwei Emissionsbereiche in Reihe geschaltet.

Die Emissionsbereiche 2 weisen jeweils eine n-leitende Halbleiterschicht 21 und eine p-leitende Halbleiterschicht 23 auf, zwischen denen eine aktive Schicht 22 angeordnet ist, welche mittels eines pn-Übergangs, einer Doppelheterostruktur, einer Einfach-Quantentopfstruktur oder einer Mehrfach-Quantentopfstruktur zur Strahlungserzeugung vorgesehen ist.

Eine erste Leiterbahn 6A ist vom Anodenanschlussbereich 5 unter einen der Emissionsbereiche 2 gezogen. Beispielsweise ist die p-leitende Schicht 23 mittels der Leiterbahn 6A elektrisch angeschlossen. Eine zweite Leiterbahn 6B erstreckt sich ausgehend von der n-leitenden Schicht 21 in Richtung der Rückseite des Halbleiterchips 1 - d.h. von der Emissionsfläche 200 weg - durch die aktive Schicht 22 und die p-leitende Schicht 23 hindurch. Die zweite Leiterbahn 6B verläuft vorliegend in Richtung zur Rückseite auch durch die erste Leiterbahn 6A hindurch.

Bei dem ersten Ausführungsbeispiel der Figur 1 liegt die zweite Leiterbahn 6B seitlich des ihr zugeordneten Emissionsbereichs 2 frei und ist mittels des Kathodenanschlussbereichs 4 elektrisch anschließbar. Bei der vorliegenden Variante ist die zweite Leiterbahn 6B dagegen unter einen weiteren Emissionsbereich 2 gezogen, um die p-leitende Schicht 23 dieses Emissionsbereichs elektrisch anzuschließen. Stattdessen erstreckt sich eine dritte Leiterbahn 6C von der n-leitenden Schicht 21 dieses weiteren Emissionsbereichs 2 durch die aktive Schicht 22, die p-leitende Schicht 23 und die zweite Leiterbahn 6B hindurch in Richtung der Rückseite des Halbleiterchips 1 und ist seitlich neben die Emissionsbereiche 2 gezogen, wo sie mittels des Kathodenanschlussbereichs 4 elektrisch anschließbar ist.

Die zweite Leiterbahn 6B ist gegenüber der ersten Leiterbahn 6A und der dritten Leiterbahn 6C mittels einer elektrisch isolierenden Schicht, z. B. einer dielektrischen Schicht 7, elektrisch isoliert. Zwischen den p-leitenden Schichten 23 der beiden Emissionsbereiche 2 und der ersten Leiterbahn 6A bzw. der zweiten Leiterbahn 6B, welche die jeweilige p-leitende Schicht 23 elektrisch kontaktiert, kann eine Reflektorschicht 8 angeordnet sein. Die Reflektorschicht 8 kann von einer metallischen Schicht gebildet sein. Alternativ kann die Reflektorschicht 8 eine dielektrische Schicht aufweisen, welche Öffnungen enthält, durch welche sich die jeweilige Leiterbahn 6A, 6B durch die dielektrische Schicht bis zur p-leitenden Schicht 23 hin erstreckt.

Die Emissionsbereiche können, je nach gewünschtem Farbort, ein Lumineszenzkonversionselement 24 aufweisen. Eine vorderseitige Hauptfläche der Emissionsbereiche 2 kann zur Verbesserung der Lichtauskopplung strukturiert sein.

Figur 2 zeigt eine schematische Draufsicht auf einen Licht emittierenden Halbleiterchip 1 für eine Beleuchtungseinrichtung gemäß einem zweiten Ausführungsbeispiel.

Der Halbleiterchip gemäß der Figur 2 unterscheidet sich von demjenigen des ersten Ausführungsbeispiels dadurch, dass er sechzehn Emissionsbereiche 2 aufweist. Wie beim Halbleiterchip gemäß der Figur 1 sind die Emissionsbereiche spiegelsymmetrisch zu den Seitenhalbierenden S der Außenkanten des Trägersubstrats 3 angeordnet. Insbesondere sind die Emissionsbereiche 2 an den Gitterpunkten eines gedachten rechteckigen - vorliegend quadratischen - Gitters angeordnet.

Im Unterschied zum Halbleiterchip des ersten Ausführungsbeispiels ist nicht jedem Emissionsbereich ein Paar von Elektrodenanschlüssen 4, 5 zugeordnet. Zwar ist jedem Emissionsbereich 2 ein separater Anodenanschluss 5 zugeordnet. Die Emissionsbereiche 2 sind jedoch an einen gemeinsamen Kathodenanschluss angeschlossen, für den bei dem Halbleiterchip des zweiten Ausführungsbeispiels zwei Kathodenanschlussbereiche 4 vorgesehen sind. Die Führung der Leiterbahnen 6 von den Anodenanschlüssen 5 zu den jeweiligen Emissionsbereichen 2 kann dabei in analoger Weise zu der im Zusammenhang mit Figur 4 erläuterten Ausgestaltung erfolgen.

Figur 3 zeigt eine schematische Draufsicht auf die Vorderseite eines Halbleiterchips 1 für eine Beleuchtungseinrichtung gemäß einem dritten Ausführungsbeispiel.

Der Halbleiterchip gemäß dem dritten Ausführungsbeispiel weist einen ersten Emissionsbereich 2A auf, der in Draufsicht auf die Vorderseite des Halbleiterchips 1 zentral auf dem Trägerkörper 3 angeordnet ist. In lateraler Richtung wird der erste Emissionsbereich 2A von zwölf weiteren Emissionsflächen 2B umgeben. Die weiteren Emissionsbereiche 2B sind an den Kanten und Ecken eines gedachten Rechtecks, das um den ersten Emissionsbereich 2A herum verläuft, angeordnet. Die weiteren Emissionsbereiche sind derart angeordnet, dass auf jeder Ecke des gedachten Rechtecks einer der Emissionsbereiche 2B angeordnet ist und auf jeder Kante zwischen den Ecken jeweils zwei Emissionsbereiche 2B angeordnet sind. Somit umgeben die Emissionsbereiche 2B den ersten Emissionsbereich 2A kettenartig.

Bei dem vorliegenden Ausführungsbeispiel sind alle Emissionsbereiche 2A, 2B mittels der Leiterbahnen 6 elektrisch in Reihe geschaltet. Der Halbleiterchip 1 weist vorliegend genau einen Kathodenanschlussbereich 4 und genau einen Anodenanschlussbereich 5 auf. Die elektrische Reihenschaltung kann analog zu der im Zusammenhang mit Figur 4 erläuterten Ausgestaltung ausgeführt sein.

Jedem der Emissionsbereiche 2A, 2B ist bei dem Halbleiterchip 1 gemäß dem dritten Ausführungsbeispiel ein Paar von externen Anschlussfeldern 9 zugeordnet, mittels welchen der jeweilige Emissionsbereich 2A, 2B elektrisch überbrückbar ist. Beispielsweise kann ein Emissionsbereich 2A, 2B elektrisch überbrückt werden, indem die zwei ihm zugeordneten elektrischen Anschlussfelder 9 elektrisch leitend verbunden werden. Beispielsweise kann eine Steuereinheit 90 vorgesehen sein, die dazu ausgebildet ist, eine elektrisch leitende Verbindung zwischen den zwei Anschlussfeldern eines Paars externer elektrischer Anschlussfelder herzustellen und zu unterbrechen. Dies ist in Figur 3 mit den gestrichelten Linien 90 für eines der Paare von externen Anschlussfeldern 9 angedeutet.

Die Steuereinheit kann alternativ oder zusätzlich dazu ausgebildet sein, den Halbleiterchip mittels der Elektrodenanschlussbereiche 4,5 mit einem Betriebsstrom zu versorgen. Dabei kann die Steuereinheit dazu ausgebildet sein, eine Versorgungsspannung in Abhängigkeit von der Anzahl überbrückter Emissionsbereiche 2A, 2B einzustellen.

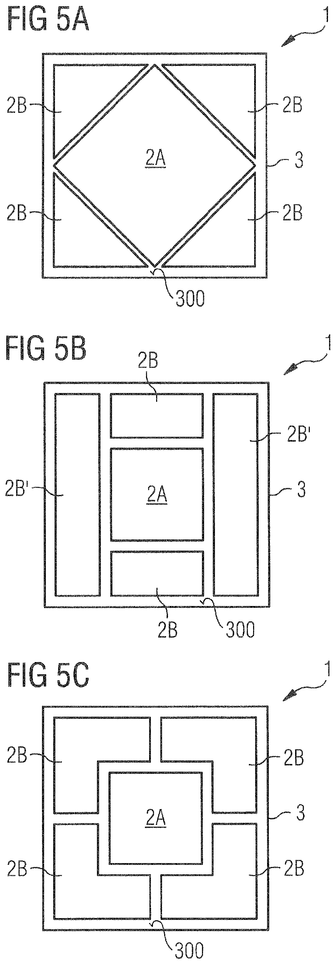

In der Figur 5A ist ein viertes Ausführungsbeispiel eines Licht emittierenden Halbleiterchips für eine Beleuchtungseinrichtung in einer schematischen Draufsicht auf die Vorderseite des Halbleiterchips 1 gezeigt.

Wie beim dritten Ausführungsbeispiel ist ein erster Emissionsbereich 2A von mehreren weiteren Emissionsbereichen 2B umgeben. Bei dem vorliegenden Ausführungsbeispiel ist der rechteckige, insbesondere quadratische, erste Emissionsbereich 2A derart auf dem rechteckigen, insbesondere quadratischen, Trägerkörper 3 angeordnet, dass in Draufsicht auf die Vorderseite die Kanten des ersten Emissionsbereichs 2A um 45° gegenüber den Kanten des Trägerkörpers 3 verdreht sind. Insbesondere verlaufen die Seitenhalbierenden der Kanten des Trägerkörpers 3 durch die Ecken des ersten Emissionsbereichs 2A.
Die weiteren Emissionsbereiche 2B sind in Draufsicht auf die Vorderseite dreieckförmig ausgebildet. Insbesondere haben die Emissionsflächen jeweils eine dreieckige Außenkontur. Vorzugsweise hat die Außenkontur die Form eines gleichschenkelig rechtwinkligen Dreiecks.

Jeweils ein weiterer Emissionsbereich 2B ist zwischen einer Kante des ersten Emissionsbereichs 2A und einer Ecke des Trägerkörpers 3 angeordnet. Insbesondere ist die Hypotenuse des von der Emissionsfläche 200 des weiteren Emissionsbereichs 2B definierten Dreiecks der Kante des ersten Emissionsbereichs 2A zugewandt und hat insbesondere die gleiche Länge wie diese Kante. Die von den beiden Katheten gebildete Ecke, welche den rechten Winkel einschließt, ist insbesondere der Ecke des Trägerkörpers 3 zugewandt.

Figur 5B zeigt eine schematische Draufsicht auf einen Licht emittierenden Halbleiterchip für eine Beleuchtungseinrichtung gemäß einem fünften Ausführungsbeispiel.

Auch bei diesem Ausführungsbeispiel ist in Draufsicht auf die Vorderseite der erste Emissionsbereich 2A von zwei zweiten Emissionsbereichen 2B und zwei dritten Emissionsbereichen 2B' umgeben. Im Gegensatz zum vorhergehenden Ausführungsbeispiel sind die Kanten des ersten Emissionsbereichs 2A vorliegend parallel zu den Kanten des Trägerkörpers 3.

In Richtung von einer der Kanten des Trägerkörpers 3 zur gegenüberliegenden Kante des Trägerkörpers 3 folgen einer der zweiten Emissionsbereiche 2B, der erste Emissionsbereich 2A und ein weiterer der zweiten Emissionsbereiche 2B in dieser Reihenfolge aufeinander. Senkrecht zu dieser Richtung sind diese drei Emissionsbereiche 2A, 2B zwischen den dritten Emissionsbereichen 2B' angeordnet. Letztere können beispielsweise streifenförmig ausgebildet sein und sich insbesondere im Wesentlichen über die gesamte Kantenlänge des Halbleiterchips erstrecken. Senkrecht zu der Richtung, in der sie aufeinander folgen haben der erste und die zweiten Emissionsbereiche 2A, 2B in Draufsicht auf die Vorderseite vorzugsweise die gleiche Abmessung.

Figur 5C zeigt eine schematische Draufsicht auf die Vorderseite eines Halbleiterchips 1 für eine Beleuchtungseinrichtung gemäß einem sechsten Ausführungsbeispiel.

Bei dem Halbleiterchip 1 gemäß dem sechsten Ausführungsbeispiel ist wiederum ein erster Emissionsbereich 2A in einem Mittelbereich der vorderseitigen Hauptfläche 300 des Trägerkörpers 3 angeordnet und von weiteren Emissionsbereichen 2B umschlossen. Vorliegend sind die weiteren Emissionsbereiche 2B in Draufsicht auf die Vorderseite L-förmig ausgeführt und derart angeordnet, dass jeweils eine Ecke des ersten Emissionsbereichs 2A in der von dem L gebildeten Hohlkehle angeordnet ist.

In den Ausführungsbeispielen der Figuren 5A, 5B und 5C sind die Elektrodenanschlussbereiche 4, 5 nicht an der vorderseitigen Hauptfläche 300 des Trägerkörpers 3 angeordnet, sondern an dessen Rückseite. Die Halbleiterchips gemäß diesen Ausführungsbeispielen sind somit zum elektrischen Anschluss von der Rückseite des Halbleiterchips 1 her vorgesehen, während die Halbleiterchips 1 gemäß den ersten drei Ausführungsbeispielen zum elektrischen Anschluss von der Vorderseite des Halbleiterchips 1 her vorgesehen sind. Die Halbleiterchips sind jedoch nicht auf diese Ausführung der Kontaktierung eingeschränkt. Vielmehr kann jeder der Halbleiterchips zum elektrischen Anschluss von der Rückseite her und/oder von der Vorderseite her ausgebildet sein.

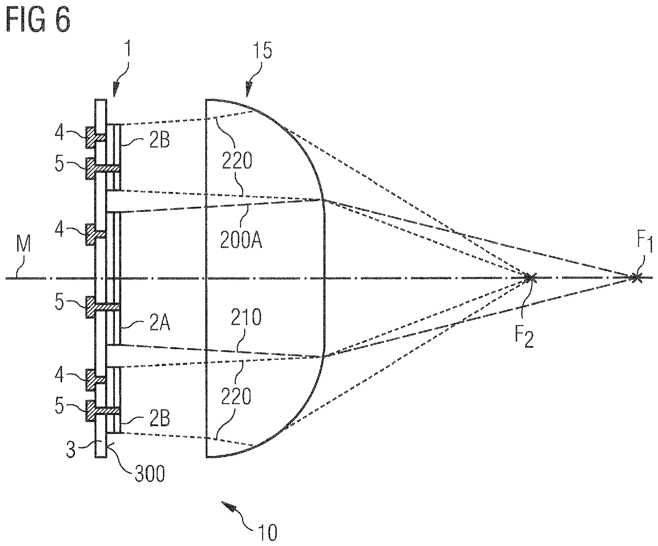

Figur 6 zeigt einen schematischen Querschnitt durch eine Beleuchtungseinrichtung gemäß einem ersten Ausführungsbeispiel.

Die Beleuchtungseinrichtung 10 weist einen Licht emittierenden Halbleiterchip 1 und ein optisches Element 15 auf. Das optische Element 15 kann beispielsweise eine Freiformlinse aufweisen. Bei dem Licht emittierenden Halbleiterchip 1 kann es sich beispielsweise um einen der Halbleiterchips gemäß einem der vorhergehenden Ausführungsbeispiele handeln.

Beispielhaft ist die Beleuchtungseinrichtung 10 bei dem ersten Ausführungsbeispiel mit dem Halbleiterchip gemäß der Figur 5B dargestellt. Die Anordnung der Emissionsbereiche 2, 2A, 2B, 2B' ist aber nicht auf dieses Ausführungsbeispiel eingeschränkt, sondern kann beispielsweise gemäß einem der übrigen Ausführungsbeispiele des Halbleiterchips 1 gewählt sein. Der Halbleiterchip 1 ist vorliegend zum rückseitigen externen elektrischen Anschluss mittels der Elektrodenanschlussbereiche 4, 5 vorgesehen, die an einer von den Emissionsbereichen 2A, 2B abgewandten Seite des Trägers 3 angeordnet sind. Jedoch kann der Halbleiterchip auch zum vorderseitigen externen elektrischen Anschluss vorgesehen sein, wie in Zusammenhang mit den ersten drei Ausführungsbeispielen des Halbleiterchips 1 erläutert. In diesem Fall sind die Elektrodenanschlussbereiche 4, 5 nicht an der Rückseite des Trägerkörper 3 ausgebildet, sondern auf der vorderseitigen Hauptfläche 300. Vorliegend ist für jeden Emissionsbereich 2A, 2B ein separater Anodenanschluss 5 und ein separater Kathodenanschluss 4 vorgesehen. Die Emissionsbereiche können aber auch parallel oder in Reihe geschaltet werden, wie im Zusammenhang mit den Figuren 2 bis 4 erläutert.

Die Beleuchtungseinrichtung ist bei dem ersten Ausführungsbeispiel mittels der Formgebung der Freiformlinse 15 und deren Anordnung zum Halbleiterchip 1 derart ausgebildet, dass von dem ersten Emissionsbereich 2A emittiertes Licht (angedeutet durch die gestrichelten Linien 210 in Figur 6) in einem ersten Brennpunkt F₁ fokussiert wird. Von den weiteren Emissionsbereichen 2B emittiertes Licht (angedeutet durch die punktierten Linien 220 in Figur 6) wird in einem zweiten Brennpunkt F₂ fokussiert, der auf einer optischen Achse der Linse 15 zwischen dem ersten Brennpunkt F₁ und dem Halbleiterchip 1 angeordnet ist.

Auf diese Weise ist der Brennpunkt des von der Beleuchtungseinrichtung 10 ausgekoppelten Strahlenbündels einstellbar. Beispielsweise kann die Beleuchtungseinrichtung 10 zum Betrieb mit einem ersten Strahlprofil so angesteuert werden, dass der erste Emissionsbereich 2A Licht emittiert und die weiteren Emissionsbereiche 2B abgeschaltet sind. Aus der Beleuchtungseinrichtung 10 wird in diesem Fall ein Strahlenbündel ausgekoppelt, das in den ersten Brennpunkt F₁ fokussiert wird.

Zum Betrieb mit einem zweiten Strahlprofil kann die Beleuchtungseinrichtung 10 so angesteuert werden, dass der erste Emissionsbereich 2A abgeschaltet ist und die weiteren Emissionsbereiche 2B Licht 220 emittieren. In diesem Fall wird aus der Beleuchtungseinrichtung ein Strahlenbündel ausgekoppelt, das im zweiten Brennpunkt F₂ fokussiert ist.

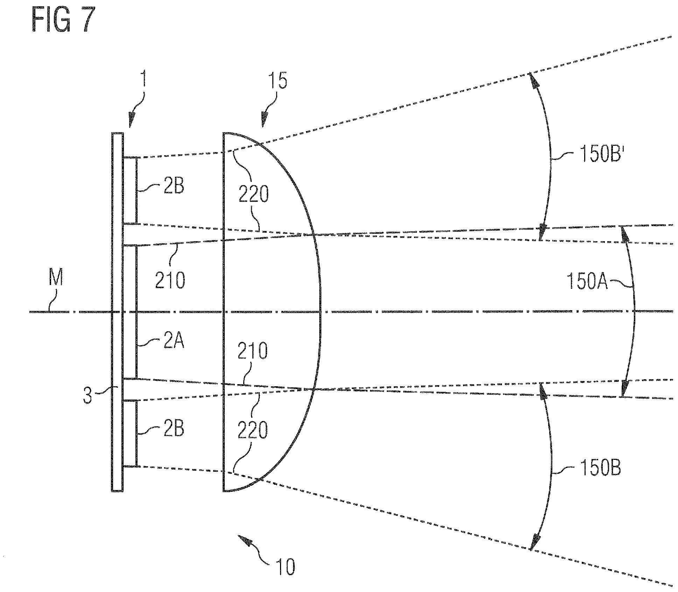

Figur 7 zeigt einen schematischen Querschnitt durch eine Beleuchtungseinrichtung gemäß einem zweiten Ausführungsbeispiel. Die elektrische Verschaltung der Emissionsbereiche 2A, 2B mit den Leiterbahnen 6 und den Elektrodenanschlussbereichen 4, 5 ist in Figur 7 der Übersichtlichkeit halber weggelassen.

Die Beleuchtungseinrichtung 10 gemäß dem zweiten Ausführungsbeispiel unterscheidet sich dadurch von der Beleuchtungseinrichtung gemäß dem ersten Ausführungsbeispiel, dass sie zur Abstrahlung eines divergenten Strahlenbündels ausgebildet ist. Mittels der einzeln ansteuerbaren Emissionsbereiche 2A, 2B ist der Öffnungswinkel des von der Beleuchtungseinrichtung 10 ausgekoppelten Strahlenbündels einstellbar.

Wie beim vorhergehenden Ausführungsbeispiel handelt es sich bei dem optischen Element 15 beispielsweise um eine zum Halbleiterchip 1 ortsfeste Linse, insbesondere eine Freiformlinse. Formgebung und Anordnung der Linse 15 sind jedoch so gewählt, dass die Beleuchtungseinrichtung gemäß dem Ausführungsbeispiel der Figur 7 dazu ausgebildet ist, von dem ersten Emissionsbereich 200 emittiertes Licht 210 in einen ersten Abstrahlwinkelbereich 150A zu lenken. Die Beleuchtungseinrichtung 10 ist weiterhin dazu ausgebildet, mittels der Formgebung der Linse und deren Anordnung zu den Emissionsbereichen 2A, 2B, von den weiteren Emissionsbereichen 2B emittiertes Licht 220 in zweite Abstrahlwinkelbereiche 150B, 150B' zu lenken.

Der erste Abstrahlwinkelbereich enthält eine Mittelachse M des Strahlenbündels. Die Mittelachse M fällt insbesondere mit der optischen Achse des optischen Elements 15 zusammen. Die zweiten Abstrahlwinkelbereiche sind von der Mittelachse M des Strahlenbündels beabstandet.

Mittels der einzeln ansteuerbaren Emissionsbereiche 2A, 2B kann auf diese Weise der Öffnungswinkel des von der Beleuchtungseinrichtung 10 ausgekoppelten Strahlenbündels eingestellt werden. Wird zur Erzeugung eines ersten Strahlprofils nur der erste Emissionsbereich 2A betrieben, hat das Strahlenbündel einen vergleichsweise kleinen Öffnungswinkel. Werden alle Emissionsbereiche 2A, 2B zur Erzeugung eines zweiten Strahlprofils betrieben, ist der Öffnungswinkel des Strahlenbündels im Vergleich zum Betrieb mit dem ersten Strahlprofil vergrößert.

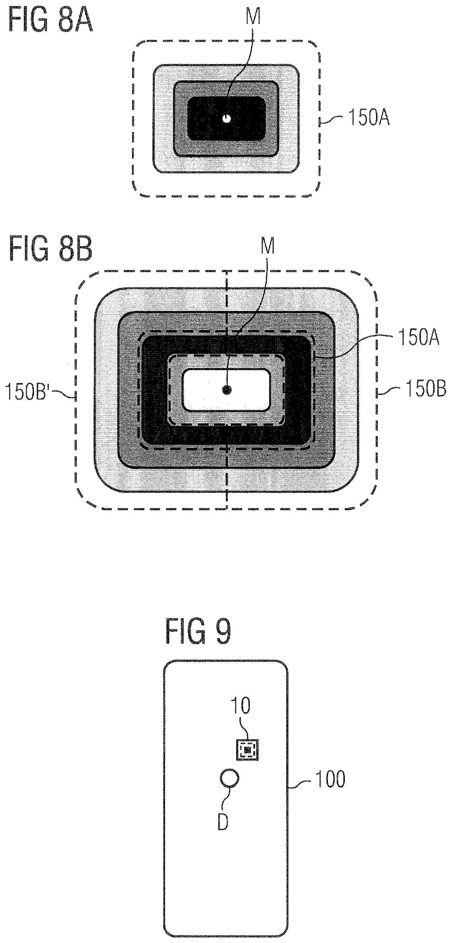

In den Figuren 8A und 8B sind das erste und das zweite Strahlprofil in einer zur Mittelachse M senkrechten Ebene schematisch dargestellt. Figur 8A und 8B zeigen dabei jeweils die ortsabhängige relative Strahlungsintensität in dieser Ebene, bezogen auf die maximale Strahlungsintensität des jeweiligen Strahlprofils. Dunkle Grautöne entsprechen in den Figuren 8A und 8B einer höheren Strahlungsintensität als helle Grautöne.

Beim ersten Strahlprofil liegt das Maximum der Strahlungsintensität auf der Mittelachse. Ausgehend von der Mittelachse fällt die Strahlungsintensität in jeder zur Mittelachse M senkrechten Richtung beispielsweise kontinuierlich ab. Außerhalb des ersten Abstrahlwinkelbereichs wird im Wesentlichen keine Strahlung emittiert. Beispielsweise ist außerhalb des ersten Abstrahlwinkelbereichs die Intensität auf 1/e² des Intensitätsmaximums abgefallen. Der erste Abstrahlwinkelbereich entspricht in der in den Figuren 8A und 8B dargestellten Ebene dem von der gestrichelten Linie 150A umschlossenen Gebiet.

Das in Figur 8B schematisch dargestellte zweite Strahlprofil weist auf der Mittelachse M kein Maximum, sondern ein lokales Minimum der Strahlungsintensität auf. Das Intensitätsmaximum der Strahlungsintensität ist dagegen in einem ringförmigen, um die Mittelachse umlaufenden Bereich enthalten. Beispielsweise ist das Intensitätsmaximum in einem ringförmigen Überlappungsbereich des ersten Abstrahlwinkelbereichs 150A und der zweiten Abstrahlwinkelbereiche 150B, 150B' angeordnet. Die zweiten Abstrahlwinkelbereiche entsprechen in der in Figur 8B dargestellten Ebene den von den strichpunktierten Linien 150B bzw. 150B' umschlossenen Gebieten. Ausgehend von der Mittelachse M steigt die Strahlungsintensität in jeder zur Mittelachse senkrechten Richtung bis zu dem Intensitätsmaximum im Überlappungsbereich and und fällt in Richtung von der Mittelachse M weg nachfolgend wieder ab, bis sie an der Außenkontur der zweiten Abstrahlbereich beispielsweise auf 1/ e² des Intensitätsmaximums abgefallen ist.

Figur 9 zeigt ein Mobiltelefon 100, das eine Kamera mit einem CCD-Detektor D zur Aufzeichnung von Bildern und eine Beleuchtungseinrichtung 10, beispielsweise gemäß einem der vorhergehenden Ausführungsbeispiele, enthält. Bei der Kamera kann es sich um eine Foto- und/oder eine Videokamera handeln. Die Beleuchtungseinrichtung kann beispielsweise als Vor- und Hauptblitz zum Aufzeichnen eines Bildes und/oder zum Aufzeichnen einer Bildfolge mit unterschiedlichen Strahlprofilen verwendet werden, wie oben erläutert.

Die Erfindung ist nicht durch die Beschreibung anhand der Ausführungsbeispiele auf diese beschränkt. Vielmehr umfasst sie jedes neue Merkmal sowie jede Kombination von Merkmalen, im Rahmen des Schutzbereichs der Patentansprüche.

## Patentansprüche

1. Beleuchtungseinrichtung (10) für eine Kamera mit einem Licht emittierenden Halbleiterchip (1), der eine Mehrzahl von Emissionsbereichen (2, 2A, 2B, 2B') enthält, und einem optischen Element (15), das dazu ausgebildet ist, von den Emissionsbereichen (2, 2A, 2B, 2B') emittiertes Licht (210, 220) zu einem Strahlenbündel zu formen, wobei
die Beleuchtungseinrichtung (10) derart ausgebildet ist, dass mittels der Emissionsbereiche (2, 2A, 2B, 2B') unterschiedliche Strahlprofile des Strahlenbündels einstellbar sind,
**dadurch gekennzeichnet, dass**
- die Emissionsbereiche einzeln ansteuerbar sind, und
- der Halbleiterchip (1) eine Halbleiterschichtenfolge mit einer zur Lichterzeugung vorgesehenen aktiven Zone aufweist, wobei
- die aktive Zone zur Ausbildung der einzelnen Emissionsbereiche (2, 2A, 2B, 2B') durchtrennt ist, oder
- die aktive Zone sich lateral durch sämtliche Emissionsbereiche (2, 2A, 2B, 2B') erstreckt und zur elektrischen Entkopplung der Emissionsbereiche ein strukturierter Kontakt zwischen den Emissionsbereichen ausgebildet ist.

2. Beleuchtungseinrichtung (10) gemäß Anspruch 1,
bei der die Emissionsbereiche (2, 2A, 2B, 2B') einem einzelnen Halbleiterchip (1) zugeordnet sind, bei dem sowohl die Halbleiterschichtenfolge als auch der elektrische Kontakt des einzelnen Halbleiterchips segmentiert sind.

3. Beleuchtungseinrichtung (10) gemäß einem der vorhergehenden Ansprüche, wobei sich die Strahlprofile hinsichtlich der räumlichen Intensitätsverteilung und/oder der räumlichen Farbortverteilung in einer zu einer Mittelachse (M) des Strahlenbündels senkrechten Ebene unterscheiden.

4. Beleuchtungseinrichtung (10) gemäß einem der vorhergehenden Ansprüche, wobei mittels der einzeln ansteuerbaren Emissionsbereiche (2, 2A, 2B, 2B') ein Öffnungswinkel des Strahlenbündels einstellbar ist.

5. Beleuchtungseinrichtung (10) gemäß einem der vorhergehenden Ansprüche, wobei mittels der einzeln ansteuerbaren Emissionsbereiche (2, 2A, 2B, 2B') die Lage eines Brennpunkts (F₁, F₂) einstellbar ist, in welchen das Strahlenbündel von dem optischen Element (15) fokussiert wird.

6. Beleuchtungseinrichtung (10) gemäß einem der vorhergehenden Ansprüche, wobei mittels der einzeln ansteuerbaren Emissionsbereiche (2, 2A, 2B, 2B') ein erstes Strahlprofil einstellbar ist, bei dem die Strahlungsintensität auf einer Mittelachse (M) des Strahlenbündels ein lokales Minimum hat und in mindestens einer zur Mittelachse (M) senkrechten Richtung in Richtung von der Mittelachse (M) weg ansteigt und nachfolgend wieder abfällt, und ein zweites Strahlprofil einstellbar ist, bei dem die Strahlungsintensität auf der Mittelachse (M) ein Intensitätsmaximum hat und in jeder zur Mittelachse (M) senkrechten Richtung ausgehend von der Mittelachse (M) abfällt.

7. Beleuchtungseinrichtung (10) gemäß einem der vorhergehenden Ansprüche, wobei sich mindestens zwei der Emissionsbereiche (2, 2A, 2B, 2B') hinsichtlich des Farborts des vom jeweiligen Emissionsbereich (2, 2A, 2B, 2B') emittierten Lichts (210, 220) unterscheiden.

8. Beleuchtungseinrichtung (10) gemäß einem der vorhergehenden Ansprüche, wobei
- jeder Emissionsbereich (2, 2A, 2B, 2B') an einer Vorderseite des Halbleiterchips eine Emissionsfläche (200) zur Lichtauskopplung aufweist,
- jedem Emissionsbereich (2, 2A, 2B, 2B') zwei Leiterbahnen (6, 6A, 6B, 6C) des Halbleiterchips (1) zum elektrischen Anschluss des jeweiligen Emissionsbereichs (2, 2A, 2B, 2B') zugeordnet sind und
- die jeweilige Emissionsfläche (200) in Draufsicht auf die Vorderseite die zwei zugeordneten Leiterbahnen (6, 6A, 6B, 6C) überdeckt.

9. Beleuchtungseinrichtung (10) gemäß einem der vorhergehenden Ansprüche, wobei der Halbleiterchip (1) zwei externe Anschlussfelder (9) aufweist, die zum Überbrücken eines der Emissionsbereiche (2, 2A, 2B, 2B') elektrisch leitend verbindbar sind.

10. Beleuchtungseinrichtung (10) gemäß Anspruch 9 mit einer Steuereinheit (90), die dazu ausgebildet ist, zum Einstellen eines ersten Strahlprofils eine elektrisch leitende Verbindung zwischen den zwei externen Anschlussfeldern (9) herzustellen und zum Einstellen eines zweiten Strahlprofils die elektrisch leitende Verbindung zu unterbrechen.

11. Beleuchtungseinrichtung (10) gemäß einem der vorhergehenden Ansprüche, wobei ein Emissionsbereich (2, 2A) lateral von mindestens einem weiteren Emissionsbereich (2, 2B, 2B') umschlossen ist.

12. Beleuchtungseinrichtung (10) gemäß einem der vorhergehenden Ansprüche, die ein Blitzlicht ist.

13. Kamera zur Aufzeichnung von Bildern und/oder Bildfolgen mit einer Beleuchtungseinrichtung (10) gemäß einem der vorhergehenden Ansprüche.

14. Verfahren zum Betrieb der Beleuchtungseinrichtung (10) gemäß einem der Ansprüche 1 bis 12 oder der Kamera gemäß Anspruch 13, bei dem die Beleuchtungseinrichtung (10) mit einem ersten Strahlprofil und nachfolgend mit einem zweiten, von dem ersten verschiedenen Strahlprofil betrieben wird, wobei die Emissionsbereiche (2, 2A, 2B, 2B') derart angesteuert werden, dass während des Betriebs mit dem ersten Strahlprofil ein erster Emissionsbereich (2, 2A) Licht (210) emittiert und ein zweiter Emissionsbereich (2, 2B, 2B') abgeschaltet ist und während des Betriebs mit dem zweiten Strahlprofil der zweite Emissionsbereich 2, 2B, 2B') Licht (220) emittiert und der erste Emissionsbereich (2, 2A) Licht (210) emittiert oder abgeschaltet ist.

15. Verfahren gemäß Anspruch 14 zum Betrieb der Kamera gemäß Anspruch 12 zur Aufzeichnung einer Bildfolge, wobei die Kamera ein erstes Bild aufzeichnet, während die Beleuchtungseinrichtung (10) mit dem ersten Strahlprofil betrieben wird, und ein zweites Bild aufzeichnet, während die Beleuchtungseinrichtung (10) mit dem zweiten Strahlprofil betrieben wird.

16. Verfahren gemäß Anspruch 14 zum Betrieb der Kamera gemäß Anspruch 13 zum Aufzeichnen eines Bilds, wobei die Kamera einen Detektor (D) zur Erfassung des Bilds und einen Auslöser zum Starten der Aufzeichnung aufweist, mit den folgenden Schritten in der angegebenen Reihenfolge:
1) Betätigen des Auslösers zum zeitversetzten Auslösen der Erfassung des Bilds mittels des Detektors (D);
2) Betreiben der Beleuchtungseinrichtung mit dem ersten Strahlprofil vor Erfassung des Bilds mittels des Detektors (D); und
3) Betreiben der Beleuchtungseinrichtung mit dem zweiten Strahlprofil während der Erfassung des Bilds mittels des Detektors (D).

## Claims

1. Illumination device (10) for a camera comprising a light-emitting semiconductor chip (1), which contains a plurality of emission regions (2, 2A, 2B, 2B') and an optical element (15), which is configured to shape light (210, 220) emitted by the emission regions (2, 2A, 2B, 2B') to form a beam bundle, wherein
the illumination device (10) is configured in such a way that different beam profiles of the beam bundle can be set by means of the emission regions (2, 2A, 2B, 2B'),
**characterized in that**
- the emission regions are individually drivable, and
- the semiconductor chip (1) has a semiconductor layer sequence having an active zone provided for generating light, wherein
- the active zone is severed for the purpose of forming the individual emission regions (2, 2A, 2B, 2B'), or
- the active zone extends laterally through all the emission regions (2, 2A, 2B, 2B') and, for the purpose of electrical decoupling of the emission regions, a structured contact is formed between the emission regions.

2. Illumination device (10) according to Claim 1, wherein
the emission regions (2, 2A, 2B, 2B') are assigned to an individual semiconductor chip (1), in which both the semiconductor layer sequence and the electrical contact of the individual semiconductor chip are segmented.

3. Illumination device (10) according to any of the preceding claims, wherein the beam profiles differ with regard to the spatial intensity distribution and/or the spatial colour locus distribution in a plane perpendicular to a central axis (M) of the beam bundle.

4. Illumination device (10) according to any of the preceding claims, wherein an aperture angle of the beam bundle can be set by means of the individually drivable emission regions (2, 2A, 2B, 2B').

5. Illumination device (10) according to any of the preceding claims, wherein the position of a focal point (F₁, F₂) to which the beam bundle is focussed by the optical element (15) can be set by means of the individually drivable emission regions (2, 2A, 2B, 2B').

6. Illumination device (10) according to any of the preceding claims, wherein, by means of the individually drivable emission regions (2, 2A, 2B, 2B'), a first beam profile can be set, in the case of which the radiation intensity has a local minimum on a central axis (M) of the beam bundle and rises and subsequently falls again in at least one direction perpendicular to the central axis (M) in a direction away from the central axis (M), and a second beam profile can be set, in the case of which the radiation intensity has an intensity maximum on the central axis (M) and falls in every direction perpendicular to the central axis (M) proceeding from the central axis (M).

7. Illumination device (10) according to any of the preceding claims, wherein at least two of the emission regions (2, 2A, 2B, 2B') differ with regard to the colour locus of the light (210, 220) emitted by the respective emission region (2, 2A, 2B, 2B').

8. Illumination device (10) according to any of the preceding claims, wherein
- each emission region (2, 2A, 2B, 2B') has an emission area (200) for the coupling-out of light at a front side of the semiconductor chip,
- each emission region (2, 2A, 2B, 2B') is assigned to two conductor tracks (6, 6A, 6B, 6C) of the semiconductor chip (1) for the electrical connection of the respective emission region (2, 2A, 2B, 2B'), and
- the respective emission area (200) covers the two assigned conductor tracks (6, 6A, 6B, 6C) in a plan view of the front side.

9. Illumination device (10) according to any of the preceding claims, wherein the semiconductor chip (1) has two external connection zones (9) which can be electrically conductively connected for bridging one of the emission regions (2, 2A, 2B, 2B').

10. Illumination device (10) according to Claim 9 comprising a control unit (90), which is configured to produce an electrically conductive connection between the two external connection zones (9) for the purpose of setting a first beam profile and to interrupt the electrically conductive connection for the purpose of setting a second beam profile.

11. Illumination device (10) according to any of the preceding claims, wherein an emission region (2, 2A) is laterally enclosed by at least one further emission region (2, 2B, 2B').

12. Illumination device (10) according to any of the preceding claims, which is a flashlight.

13. Camera for recording images and/or image sequences comprising an illumination device (10) according to any of the preceding claims.

14. Method for operating the illumination device (10) according to any of Claims 1 to 12 or the camera according to Claim 13, in which the illumination device (10) is operated with a first beam profile and subsequently with a second beam profile, which is different from the first beam profile, wherein the emission regions (2, 2A, 2B, 2B') are driven in such a way that, during operation with the first beam profile, a first emission region (2, 2A) emits light (210) and a second emission region (2, 2B, 2B') is turned off and, during operation with the second beam profile, the second emission region (2, 2B, 2B') emits light (220) and the first emission region (2, 2A) emits light (210) or is turned off.

15. Method according to Claim 14 for operating the camera according to Claim 12 for recording an image sequence, wherein the camera records a first image while the illumination device (10) is operated with the first beam profile, and records a second image while the illumination device (10) is operated with the second beam profile.

16. Method according to Claim 14 for operating the camera according to Claim 13 for recording an image, wherein the camera has a detector (D) for detecting the image and a release mechanism for starting the recording, comprising the following steps in the order indicated:
1) actuating the release mechanism for the temporally offset triggering of the detection of the image by means of the detector (D);
2) operating the illumination device with the first beam profile before the detection of the image by means of the detector (D); and
3) operating the illumination device with the second beam profile during the detection of the image by means of the detector (D).

## Revendications

1. Dispositif d'éclairage (10) pour une caméra, présentant une puce semi-conductrice (1) qui émet de la lumière et qui contient plusieurs parties d'émission (2, 2A, 2B, 2B') et
un élément optique (15) configuré pour former en un faisceau de rayons la lumière (210, 220) émise par les parties d'émission (2, 2A, 2B, 2B'),
le dispositif d'éclairage (10) étant configuré de telle sorte que différents profils de rayons du faisceau de rayons peuvent être établis au moyen des parties d'émission (2, 2A, 2B, 2B'),
**caractérisé en ce que**
- les parties d'amission peuvent être commandées individuellement et
- la puce semi-conductrice (1) présente une succession de couches semi-conductrices présentant une zone active prévue pour la production de lumière, **en ce que**
- la zone active est découpée pour former les différentes parties d'émission (2, 2A, 2B, 2B') ou
- la zone active s'étend latéralement dans toutes les parties d'émission (2, 2A, 2B, 2B') et un contact structuré est formé entre les parties d'émission pour assurer le découplage électrique des parties d'émission.

2. Dispositif d'éclairage (10) selon la revendication 1, dans lequel les parties d'émission (2, 2A, 2B, 2B') sont associées à une seule puce semi-conductrice (1) dans laquelle tant la succession de couches semi-conductrices que le contact électrique de l'unique puce semi-conductrice sont segmentés.

3. Dispositif d'éclairage (10) selon l'une des revendications précédentes, dans lequel les profils des rayons se distinguent par la répartition spatiale de leur intensité et/ou la répartition spatiale de la couleur dans un plan perpendiculaire à l'axe central (M) du faisceau de rayons.

4. Dispositif d'éclairage (10) selon l'une des revendications précédentes, dans lequel l'angle d'ouverture du faisceau de rayons peut être réglé au moyen des différentes parties d'émission (2, 2A, 2B, 2B') aptes à être commandées.

5. Dispositif d'éclairage (10) selon l'une des revendications précédentes, dans lequel la position du plan focal (F₁, F₂) sur lequel le faisceau de rayons est focalisé par l'élément optique (15) peut être réglée au moyen des différentes parties d'émission (2, 2A, 2B, 2B') aptes à être commandées.

6. Dispositif d'éclairage (10) selon l'une des revendications précédentes, dans lequel un premier profil de rayons dans lequel l'intensité du rayonnement présente un minimum local sur l'axe central (M) du faisceau de rayons et augmente en s'éloignant de l'axe central (M) dans au moins une direction perpendiculaire à l'axe central (M) pour ensuite diminuer de nouveau peut être établi au moyen des différentes parties d'émission (2, 2A, 2B, 2B') aptes à être commandées et dans lequel un deuxième profil de rayons dans lequel l'intensité de rayonnement présente un maximum d'intensité sur l'axe central (M) et diminue partant de l'axe central (M) dans chaque direction perpendiculaire à l'axe central (M) peut être établi.

7. Dispositif d'éclairage (10) selon l'une des revendications précédentes, dans lequel au moins deux des parties d'émission (2, 2A, 2B, 2B') se distinguent l'une de l'autre en termes de couleur de la lumière (210, 220) émise par chaque partie d'émission (2, 2A, 2B, 2B').

8. Dispositif d'éclairage (10) selon l'une des revendications précédentes, dans lequel
- chaque partie d'émission (2, 2A, 2B, 2B') présente une surface (200) d'émission de lumière située sur le côté avant de la puce semi-conductrice,
- deux pistes conductrices (6, 6A, 6B, 6C) de la puce semi-conductrice (1) étant associées à chaque partie d'émission (2, 2A, 2B, 2B') pour le raccordement électrique de chaque partie d'émission (2, 2A, 2B, 2B') et
- vue en plan, chaque surface d'émission (200) recouvre les deux pistes conductrices (6, 6A, 6B, 6C) associées sur le côté avant.

9. Dispositif d'éclairage (10) selon l'une des revendications précédentes, dans lequel la puce semi-conductrice (1) présente deux champs de raccordement (9) qui peuvent être reliés de manière électriquement conductrice pour ponter l'une des parties d'émission (2, 2A, 2B, 2B').

10. Dispositif d'éclairage (10) selon la revendication 9, présentant une unité de commande (90) configurée pour établir une liaison électriquement conductrice entre deux champs de raccordement (9) externes en vue de former un premier profil de rayons et pour interrompre la liaison électriquement conductrice en vue de former un deuxième profil de rayons.

11. Dispositif d'éclairage (10) selon l'une des revendications précédentes, dans lequel une partie d'émission (2, 2A) est entourée latéralement par au moins une autre partie d'émission (2, 2B, 2B').

12. Dispositif d'éclairage (10) selon l'une des revendications précédentes, qui est une lampe à éclairs.

13. Caméra d'enregistrement d'images et/ou de successions d'images, présentant un dispositif d'éclairage (10) selon l'une des revendications précédentes.

14. Procédé d'utilisation d'un dispositif d'éclairage (10) selon l'une des revendications 1 à 12 ou de la caméra selon la revendication 13, dans lequel le dispositif d'éclairage (10) est utilisé à un premier profil de rayons et ensuite à un deuxième profil de rayons différent du premier profil de rayons, les parties d'émission (2, 2A, 2B, 2B') étant commandées de telle sorte que pendant le fonctionnement au premier profil de rayons, une première partie d'émission (2, 2A) émet de la lumière (210) et une deuxième partie d'émission (2, 2B; 2B') est débranchée et que pendant le fonctionnement au deuxième profil de rayons, la deuxième partie d'émission (2, 2B, 2B') émet de la lumière (220) et la première partie d'émission (2, 2A) émet de la lumière (210) ou est débranchée.

15. Procédé selon la revendication 14 pour l'utilisation de la caméra selon la revendication 12 en vue d'enregistrer une succession d'images, la caméra enregistrant une première image pendant que le dispositif d'éclairage (10) est utilisé au premier profil de rayons et enregistre une deuxième image pendant que le dispositif d'éclairage (10) est utilisé au deuxième profil de rayons.

16. Procédé selon la revendication 14 pour l'utilisation de la caméra selon la revendication 13 en vue d'enregistrer une image, la caméra présentant un détecteur (D) qui saisit l'image et un déclencheur qui lance l'enregistrement, le procédé présentant les étapes suivantes dans la succession indiqués :
1) actionnement du déclencheur en vue de déclencher avec un décalage temporel la saisie de l'image au moyen du détecteur (D),
2) utilisation du dispositif d'éclairage au premier profil de rayons avant la saisie de l'image au moyen du détecteur (D) et
3) utilisation du dispositif d'éclairage au deuxième profil de rayons pendant la saisie de l'image au moyen du détecteur (D).
